(19) Europäisches Patentamt
European Patent Office
Office européen des brevets

(11) Veröffentlichungsnummer: **0 311 881 A2**

# (12) EUROPÄISCHE PATENTANMELDUNG

(21) Anmeldenummer: **88116481.8**

(22) Anmeldetag: **05.10.88**

(51) Int. Cl.[4]: **B23K 35/363 , H05K 3/34 , C08L 71/00 , //(C08L71/00, 71:00)**

(30) Priorität: **10.10.87 DE 3734331**

(43) Veröffentlichungstag der Anmeldung: **19.04.89 Patentblatt 89/16**

(84) Benannte Vertragsstaaten: **BE CH DE ES FR GB IT LI NL SE**

(71) Anmelder: **BASF Aktiengesellschaft
Carl-Bosch-Strasse 38
D-6700 Ludwigshafen(DE)**

(72) Erfinder: **Dexheimer, Edward Michael
26270 East River Road
Grosse Ile Mich. 48138(US)**
Erfinder: **Greif, Norbert, Dr.
Im Woogtal 3
D-6719 Bobenheim(DE)**
Erfinder: **Tschang, Chung-Ji, Dr.
Hinterbergstrasse 31
D-6702 Bad Duerkheim(DE)**
Erfinder: **Trapp, Horst, Dr.
Johann-Sebastian-Bach-Strasse 10a
D-6831 Plankstadt(DE)**
Erfinder: **Gotsmann, Guenther, Dr.
Max-Beckmann-Strasse 15
D-6710 Frankenthal(DE)**
Erfinder: **Glaser, Klaus
Neuweg 14
D-6704 Mutterstadt(DE)**

## (54) Verwendung von Alkylenoxid-Addukten in Flussmitteln und Umschmelzflüssigkeiten.

(57) Verwendung von wasserlöslichen Anlagerungsprodukten von Alkylenoxiden mit 2 bis 4 C-Atomen an phenolische OH-Gruppen enthaltende Verbindungen als Flußmittel und Umschmelzflüssigkeiten bei der Herstellung von Leiterplatten.

EP 0 311 881 A2

# Verwendung von Alkylenoxid-Addukten in Flußmitteln und Umschmelzflüssigkeiten

Bei der Herstellung von Leiterplatten ist es erforderlich, die Leiterbahnen vor Korrosion zu schützen und an den Stellen, an denen Bauteile aufgelötet werden sollen, eine gute Lötbarkeit der Kontaktflächen oder Lötaugen sicherzustellen. Hierzu werden die Leiterbahnen üblicherweise mit einem Überzug aus einer Zinn-Blei-Legierung (Lot) versehen. Dies kann nach zwei üblichen, dem Fachmann bekannten Vorgehensweisen geschehen:

Bei der Herstellung von Leiterplatten nach dem Subtraktionsverfahren wird eine Zinn-Blei-Legierung auf den späteren Leiterbahnen galvanisch auf Kupfer abgeschieden. Dann wird die nicht benötigte Kupfer-Fläche abgeätzt, wobei die Zinn-Blei-Legierung als Ätzresist dient. Man erhält hierbei Kupfer-Leiterbahnen, deren Oberfläche durch die Zinn-Blei-Schicht geschützt ist und deren Flanken jedoch ungeschützt sind. Durch eine thermische Nachbehandlung wird nun bewirkt, daß die Zinn-Blei-Legierung schmilzt und auch die Flanken der Kupfer-Bahnen bedeckt. Um das zu erreichen, wird die Leiterplatte entweder in eine Flüssigkeit getaucht, deren Temperatur über dem Schmelzpunkt der Zinn-Blei-Legierung liegt oder die Leiterplatte wird mit einer Flüssigkeit benetzt und dann unter Einwirkung von z.B. Infrarot-Strahlung als Wärmequelle auf die zum Umschmelzen erforderliche Temperatur erhitzt. Die in diesen Fällen verwendeten Flüssigkeiten werden als Umschmelzflüssigkeiten bezeichnet.

Gemäß dem zweiten üblichen Verfahren werden die Leiterbahnen durch eine sog. Lötstoppmaske, z.B. einen Polymerfilm, geschützt. Sie brauchen dann nicht durch eine Lot-Oberfläche geschützt zu werden. Jedoch müssen die Kontaktflächen und die Lötaugen, die nicht mit der Lötstoppmaske bedeckt sind und auf denen später die Bauteile aufgelötet werden sollen, lötbar gemacht werden. Hierzu wird die Leiterplatte kurzzeitig in geschmolzenes Lot, üblicherweise Zinn-Blei-Lot, getaucht, wobei die sog. Heiß-Verzinnung an den Stellen erfolgt, die nicht von der Lötstoppmaske bedeckt sind. Vor diesem Tauchvorgang muß die Leiterplatte in ein Flußmittel getaucht werden, das folgende Aufgaben erfüllen muß:

Das Flußmittel muß die Leiterplatten gut benetzen können. Zur Erzeugung einer blanken und oxidfreien Kupferoberfläche auf den mit Lot zu verzinnenden Flächen muß es möglich sein, daß dem Flußmittel Aktivatoren zugesetzt werden können. Das Flußmittel sollte eine gute Wärmeübertragung in der Aufheizzone der verwendeten Vorrichtung aufweisen. Weiterhin muß es Fehldepositionen von Lot auf den Lötstoppmasken unterbinden können.

Nach dem anschließenden Tauchen in das geschmolzene Lot wird der Lot-Überschuß entweder in einem Luftstrom entfernt (Hot-Air-Levelling) oder aber das Lot-Bad ist mit dem Flußmittel überschichtet und es wird in dem Flußmittel eine Strömung erzeugt, die den Lot-Überschuß entfernt (Hot-Oil-Levelling).

Daraus ist ersichtlich, daß ein zweckmäßiges Flußmittel eine ganze Reihe von Funktionen zu erfüllen hat.

Die in der Technik verwendeten Umschmelzflüssigkeiten und Flußmittel, in der Regel sind es organische Flüssigkeiten, sollen von den Leiterplatten ohne Probleme abgewaschen werden können. Sie müssen thermisch beständig sein und sollten bei hohen Temperaturen keine Rauchgase oder toxische Gase abgeben oder Zersetzungsprodukte bilden. Sie müssen schwer entflammbar sein. Darüber hinaus sollen sie die Leiterplatten gut benetzen können. Sie sollen zweckmäßigerweise löslich oder mischbar in Wasser sein und verträglich mit Zusätzen, beispielsweise mit den auf Kupfer reduzierend wirkenden Aktivatoren. Sie sollen im Abwasser möglichst nicht schaumbildend sein und eine gute biologische Abbaubarkeit aufweisen.

Während beim Umschmelzen in einem Bad durch die relativ langen Standzeiten die thermische Stabilität und das Nichtauftreten von festen, unlöslichen Zersetzungsprodukten von besonderer Wichtigkeit ist, muß bei den Flußmitteln bevorzugt darauf geachtet werden, daß Fehldepositionen von Lot vermieden werden und daß die Viskosität den apparativen Erfordernissen angepaßt werden kann.

Für die oben genannten Aufgaben werden üblicherweise Umschmelzöle und Flußmittel auf der Basis von Alkylphenolethoxylaten oder Polyethylenglykolen bzw. Ethylenglykol-Propylenglykol-Blockcopolymerisaten verwendet, die jedoch eine Reihe von Nachteilen aufweisen. So entstehen aus Nonylphenolethoxylaten im Abwasser fischtoxische Abbauprodukte. Darüber hinaus bilden Alkylphenolethoxylate beim Mischen mit Wasser innerhalb gewisser Konzentrationen Gele und sind deshalb nur schwer von der Leiterplatte abzuwaschen. Produkte auf der Basis von Polyethylenglykol oder Ethylenglykol-Propylenglykol-Blockcopolymerisaten dagegen werden bei Temperaturen um 200 °C relativ stark abgebaut und führen deshalb zu erheblicher Rauch- und Geruchsbelästigung. Aus der DE-OS 27 41 312 sind beispielsweise Flußmittel auf der Basis von Blockcopolymeren aus Polyoxyethylen und Polyoxypropylen und/oder Trimethylolalkan-Derivaten davon bekannt. Solche Polymere sind als Umschmelzflüssigkeiten nicht hinreichend temperaturstabil und bilden beim Mischen mit Wasser teilweise ebenfalls Gele, wodurch ihre Abwaschbarkeit von der

Leiterplatte beeinträchtigt wird.

Aus der nicht vorveröffentlichten DE-Patentanmeldung P 37 19 634. 0 ist die Verwendung von Alkylenoxid-Addukten von 3- bis 6-wertigen aliphatischen Alkoholen als Grundstoff für Flußmittel und Umschmelzflüssigkeiten bei der Herstellung von Leiterplatten bekannt. Diese Produkte sind sehr gut von der Leiterplatte abwaschbar und zeichnen sich darüber hinaus durch einen sehr hohen Flammpunkt aus, was aus sicherheitstechnischer Sicht sehr wichtig ist, weil bei der Verwendung von Flußmitteln und Umschmelzflüssigkeiten mit zu niedrigem Flammpunkt unter ungünstigen Bedingungen Brände entstehen können.

Beim Umschmelzen im Bad und bei der Heißverzinnung mit Hot-Oil-Levelling werden wegen der angestrebten langen Standzeiten oft so extreme Anforderungen hinsichtlich der thermischen Stabilität gestellt, daß selbst die oben angeführten Alkoxylate von 3- bis 6-wertigen aliphatischen Alkoholen nicht immer den Ansprüchen genügen. Auch erscheint es unter dem Aspekt der Sicherheit ratsam, den Flammpunkt von Flußmitteln und Umschmelzflüssigkeiten noch weiter anzuheben.

Aufgabe der Erfindung ist es, neue Flußmittel und Umschmelzflüssigkeiten für die Herstellung von Leiterplatten zur Verfügung zu stellen. Die hierfür zu verwendenden Stoffe sollen eine verbesserte thermische Stabilität aufweisen und einen so hohen Flammpunkt haben, daß sie auch ohne großen maschinenbautechnischen Aufwand einen sicheren Betrieb ermöglichen.

Die Aufgabe wird erfindungsgemäß gelöst durch Verwendung von wasserlöslichen Alkylenoxid-Addukten der Formeln

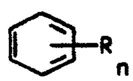 (I), 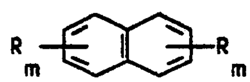 (II) und/oder

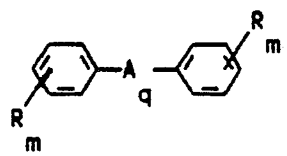 (III) ,

in denen

$$R = -O-(-CH_2-\underset{|}{\overset{R^1}{C}}H-O-)_p-H,$$

$$R^1 = H,\ CH_3,\ C_2H_5,$$

$$A = -CH_2-,\ -\overset{CH_3}{\underset{CH_3}{C}}-,\ -O-\ \text{oder}\ -\overset{O}{\underset{O}{S}}-,$$

$n$ = 2 oder 3, $m$ = 1 oder 2, $p$ = 3 bis 15 und $q$ = 0 oder 1

bedeuten, als Grundstoff für Flußmittel und Umschmelzflüssigkeiten bei der Herstellung von Leiterplatten. Die Verbindungen der Formeln I bis III sind bekannt. Sie sind durch Umsetzung von 2 bis 4 phenolische OH-Gruppen aufweisenden Verbindungen der Formeln

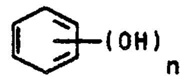 (IV)

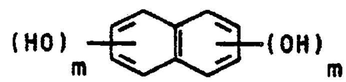 (V)

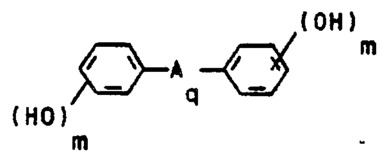 (VI)

in denen n = 2 oder 3, m = 1 oder 2, q = 0 oder 1 und

A = $-CH_2-$, 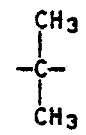 , −O− oder 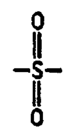

bedeuten, mit Alkylenoxiden mit 2 bis 4 C-Atomen erhältlich. Als Alkylenoxide kommen Ethylenoxid, Propylenoxid, 1,2-Butylenoxid und Isobutylenoxid in Betracht.

Die Formeln IV bis VI umfassen beispielsweise folgende Verbindungen:

Resorcin, Hydrochinon, 1,5-Dihydroxynaphthalin, 2,6-Dihydroxynaphthalin, 1,6-Dihydroxynaphthalin, 2,3-Dihydroxynaphthalin, 4,4′-Dihydroxybiphenyl, 2,2′-Dihydroxybiphenyl, 4,4′-Dihydroxydiphenylmethan, Bisphenol A, 4,4′-Dihydroxydiphenylether und 4,4′-Dihydroxydiphenylsulfon. Bevorzugt sind Resorcin, Hydrochinon und Bisphenol A.

Die erfindungsgemäß zu verwendenden Alkylenoxid-Addukte sind aufgebaut im Hinblick auf die Alkylenoxideinheiten ausschließlich aus Ethylenoxid oder aus Ethylenoxid zusammen mit Propylenoxid und/oder Butylenoxid. Dabei beträgt der Anteil an Propylenoxid und/oder Butylenoxid höchstens 25 Mol%, bezogen auf die Gesamtmenge an Alkylenoxid. Pro Mol phenolische OH-Gruppe der Verbindungen IV bis VI lagert man 3 bis 15, vorzugsweise 5 bis 12 Mol Ethylenoxid und gegebenenfalls Propylenoxid und/oder Butylenoxide an. Bei den Verbindungen der Formeln I bis III liegen die unterschiedlichen Alkylenoxid-Einheiten entweder in statistischer Verteilung oder in Form von Blöcken vor, z.B. Ethylenoxid-Blöcke und Propylenoxid-Blöcke oder Butylenoxid-Blöcke. Bevorzugt werden alkoxylierte Verbindungen der Formeln I bis III eingesetzt, die durch Anlagerung von 5 bis 12 Ethylenoxid-Einheiten an eine phenolische OH-Gruppe einer Verbindung der Formeln IV bis VI erhältlich sind, wobei die phenolischen Verbindungen vorzugsweise 2 phenolische OH-Gruppen aufweisen. Solche Additionsprodukte sind beispielsweise Verbindungen der Formel

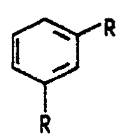 (Ia)

in der R = $-O\{-CH_2-CH_2-O\}_p-H$ und p = 5 bis 12 bedeuten, Verbindungen der Formel

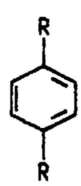 (Ib)

in der R die in Ia angegebene Bedeutung hat und Verbindungen der Formel

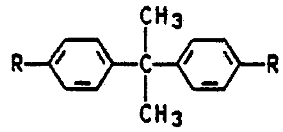

(IIIa)

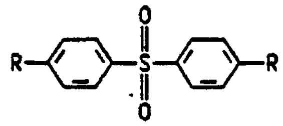

(IIIb) und

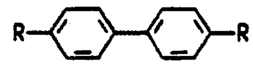

(IIIc)

worin R jeweils die in der Formel Ia angegebene Bedeutung besitzt. Hervorzuheben ist, daß die Verbindungen der Formel IIIb eine relativ hohe Viskosität aufweisen.

Zur Erzielung der maximalen thermischen Stabilität ist die ausschließliche Verwendung von Ethylenoxid bevorzugt. Von besonderem Interesse sind Umsetzungsprodukte von Resorcin mit Ethylenoxid, die pro phenolische OH-Gruppe 5 bis 10 Ethylenoxid-Einheiten angelagert enthalten.

Wie oben angegeben, zeichnen sich die erfindungsgemäß zu verwendenden Addukte besonders durch ihre thermische Beständigkeit, durch die allenfalls minimale Bildung unlöslicher Verkohlungsprodukte, durch beliebige Mischbarkeit mit Wasser, durch hervorragende Abwaschbarkeit von der Leiterplatte sowie durch Schaumarmut im Abwasser aus. Sie können allein oder in Mischung untereinander eingesetzt werden. Wegen der guten Mischbarkeit ist auch der Einsatz in Mischung mit anderen Mitteln möglich.

Bei der praktischen Verwendung der Alkylenoxid-Addukte (man kann selbstverständlich auch Mischungen der erfindungsgemäß zu verwendenden Alkylenoxid-Addukte als Flußmittel und Umschmelzflüssigkeiten einsetzen) enthalten diese neben gegebenenfalls üblichen Zusätzen, z.B. einem Tensid (in Mengen von 0,5 bis 25 Gew.%, bezogen auf die fertigen Formulierungen), die üblichen Aktivatoren. Hierbei handelt es sich beispielsweise um Säurehalogenide organischer Säuren, um Hydrochloride oder Hydrobromide von aliphatischen geradkettigen oder cyclischen Aminen, wie Triethylamin oder Morpholin, oder von Aminosäuren sowie um Chlor- bzw. Bromwasserstoff selbst. Eine Übersicht über Aktivatoren gibt die EP-A-0 201 150. Für den Einsatz als Flußmittel für die Heißverzinnung mit Hot-Air-Levelling kann der Aktivator in Form einer wäßrigen Lösung zugesetzt werden. Der Aktivator ist in Mengen von 0,5 bis 4 Gew.% in der gebrauchsfertigen Formulierung enthalten. Für den Einsatz im IR-Umschmelzverfahren kann eine Verdünnung mit leichtflüchtigen Lösemitteln, beispielsweise Isopropanol in einer Menge von 30 bis 65 Gew.%, bezogen auf die Gesamtmenge, vorgenommen werden. Es versteht sich von selbst, daß dann der Vorteil der Schwerentflammbarkeit der erfindungsgemäß angewandten Substanzen verlorengeht. Bei einem Einsatz als Umschmelzflüssigkeit oder als Flußmittel für die Heißverzinnung mit Hot-Oil-Levelling darf wegen der hohen Temperatur kein Wasser oder ein sonstiges leichtflüchtiges Lösemittel enthalten sein.

Die in den Beispielen angegebenen Teile sind Gewichtsteile.

Beispiel 1

Man setzt eine Mischung aus 80 Teilen eines Umsetzungsproduktes aus 1 Mol Resorcin mit 14 Mol Ethylenoxid, 2 Teilen Glycinhydrochlorid (als Aktivator), 0,1 Teilen Nonylphenolethoxylat mit 10 Mol Ethylenoxid und 17,9 Teilen Wasser als Flußmittel für die Heiß-Verzinnung nach dem Hot-Air-Levelling ein.

Beispiel 2

Man setzt eine Mischung aus 80 Teilen eines Umsetzungsproduktes aus 1 Mol Bisphenol A mit 16 Mol Ethylenoxid, 2,5 Teilen Glutaminsäurehydrobromid (als Aktivator) und 17,5 Teilen Wasser als Flußmittel für die Heiß-Verzinnung nach dem Hot-Air-Levelling ein.

Beispiel 3

Man setzt eine Mischung aus 20 Teilen eines Umsetzungsproduktes aus 1 Mol Bis-4,4′-(hydroxyphenyl)sulfon mit 20 Mol Ethylenoxid, 20 Teilen eines Umsetzungsproduktes aus Glycerin mit 12 Mol Ethylenoxid, 3 Teilen Triethanolaminhydrobromid (als Aktivator), 0,5 Teilen Nonylphenolethoxylat mit 10 Mol Ethylenoxid, 5 Teilen Wasser und 51,5 Teilen Isopropanol als Umschmelzmittel bei der Infrarot-Umschmelzung ein.

## Ansprüche

1. Verwendung von wasserlöslichen Alkylenoxid-Addukten der Formeln

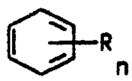 (I), 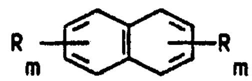 (II) und/oder

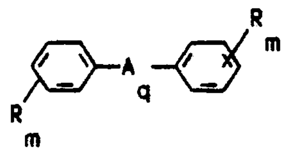 (III) ,

in denen

$R = -O-(-CH_2-\overset{R^1}{\overset{|}{C}}H-O-)_p-H,$

$R^1 = H,\ CH_3,\ C_2H_5,$

$A = -CH_2-,\ -\overset{CH_3}{\overset{|}{\underset{CH_3}{\underset{|}{C}}}}-,\ -O-$ oder $-\overset{O}{\overset{\|}{\underset{O}{\underset{\|}{S}}}}-$ ,

$n = 2$ oder $3$, $m = 1$ oder $2$, $p = 3$ bis $15$ und $q = 0$ oder $1$

bedeuten, als Grundstoff für Flußmittel und Umschmelzflüssigkeiten bei der Herstellung von Leiterplatten.

2. Verwendung nach Anspruch 1, dadurch gekennzeichnet, daß der Substituent R in den Formeln I bis III für $-O(-CH_2-CH_2-O)_p H$ mit $p = 5$ bis $12$ steht.

3. Verwendung nach Anspruch 1, dadurch gekennzeichnet, daß man als Alkylenoxid-Addukte Verbindungen der Formel

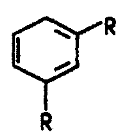 (Ia)

einsetzt, in der $R = -O(-CH_2-CH_2-O)_p-H$ und $p = 5$ bis $12$ bedeuten.

4. Verwendung nach Anspruch 1, dadurch gekennzeichnet, daß man als Alkylenoxid-Addukte Verbindungen der Formel

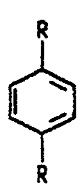 (Ib)

einsetzt, in der R = $-O\{-CH_2-CH_2-O\}-_p-H$ und p = 5 bis 12 bedeuten.

5. Verwendung nach Anspruch 1, dadurch gekennzeichnet, daß man als Alkylenoxid-Addukte Verbindungen der Formel

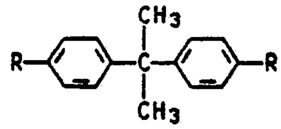

(III)

einsetzt, in der R = $-O\{-CH_2-CH_2-O\}_p-H$ und p = 5 bis 12 bedeuten.

6. Verwendung nach Anspruch 1, dadurch gekennzeichnet, daß man als Alkylenoxid-Addukte Verbindungen der Formel

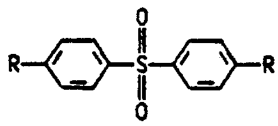

oder

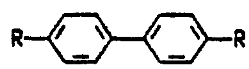

einsetzt, in der R = $-O\{-CH_2-CH_2-O\}_p-H$ und p = 5 bis 12 bedeuten.